# EUROPEAN PATENT SPECIFICATION

(11) **EP 1 083 582 B1**
(45) Date of publication and mention of the grant of the patent: **10.12.2008**
(21) Application number: 00119286.3
(22) Date of filing: 06.09.2000
(51) Int. Cl.: H01G 9/20, H01L 51/30

(54) **Dye sensitized photoelectrochemical cell**
Farbstoffsensiblisierte photoelektrochemische Zelle
Cellule photoelectrochimique sensibilisée par des chromophores

(30) Priority: 07.09.1999 JP 25275499
(43) Date of publication of application: 14.03.2001
(73) Proprietor: FUJIFILM Corporation, Minato-ku Tokyo (JP)
(72) Inventor: Watanabe, Tetsuya,, Kanagawa (JP)
(74) Representative: Grünecker, Kinkeldey, Stockmair & Schwanhäusser Anwaltssozietät

(56) References cited:
- EP-A- 0 924 724
- DE-A- 2 936 730
- TRIBUTSCH H: "Elektrochemische Untersuchung über die Sensibiliserungseigenschaften und das photochemische Verhalten von Pseudoisocyanin-Farbstoffaggreg aten an ZnO-Elektroden" BER.BUNSENGES.PHYS.CHEM, WEINHEIM, DE, vol. 73, no. 6, 1969, pages 582-590, XP002124850

## Description

### FIELD OF THE INVENTION

This invention relates to a photoelectric conversion device, more particularly, to a photoelectric conversion device using dye-sensitized semiconductor particles. The invention also relates to a photoelectric cell comprising the device.

### BACKGROUND OF THE INVENTION

Studies of photovoltaic power generation has been directed chiefly to development of monocrystalline silicon solar cells, polycrystalline silicon solar cells, amorphous silicon solar cells, and compound solar cells using cadmium telluride, copper indium selenide, etc., and some of them have been put to practical use. It is required for spread of solar cells to overcome such difficulties as a high production cost, a short supply of raw materials, and a long energy payback time. Although many solar cells using organic materials have been proposed aiming at an increase of working area and a reduction of cost, they have a low conversion efficiency and poor durability.

Under these circumstances, Nature, vol. 353, pp. 737-740 (1991) and U.S. Patent 4,927,721 discloses a photoelectric conversion device using dye-sensitized semiconductor particles, a solar cell comprising the device, and materials and techniques for producing them. The proposed cell is a wet type solar cell comprising, as a work electrode, a porous thin film of titanium dioxide spectrally sensitized by a ruthenium complex. A primary advantage of this system is that an inexpensive oxide semiconductor, such as titanium dioxide, can be used without being highly purified so that a photoelectric conversion device can be supplied at a competitive price. A secondary advantage is that the sensitizing dye used shows a broad absorption spectrum so that substantially the whole range of visible light can be converted to electricity.

One of the pending problems of conventional dye-sensitized photoelectric conversion devices is that the ruthenium complex used as a sensitizing dye is expensive. It has therefore been demanded to develop a photoelectric conversion device sensitized with an economical organic dye. Examples of organic dyes for use in photoelectric conversion devices are given in Chemistry Letters, pp. 753-754 (1988), but the conversion efficiency achieved is still insufficient, and it is impossible to arbitrarily vary the conversion wavelength region.

### SUMMARY OF THE INVENTION

An object of the invention is to provide an organic dye-sensitized photoelectric conversion device and a photoelectric cell using the same, which are inexpensive and achieve high conversion efficiency.

Other objects and effects of the present invention will become apparent from the following description.

The above-described objects of the present invention have been achieved by providing the following photoelectric conversion devices and photoelectric cell.
(1) A photoelectric conversion device comprising semiconductor particles sensitized with at least one dye represented by formula (I): 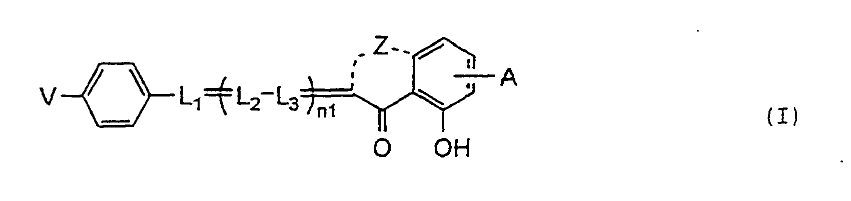 wherein Z represents a single bond or an atomic group necessary to complete a 5- to 9-membered ring, the atomic group being made up of atoms selected from hydrogen, carbon, oxygen, nitrogen and sulfur; L₁, L₂ and L₃ each represent a nitrogen atom or a substituted or unsubstituted methine group; n1 represents 0, 1 or 2; V represents a substituted or unsubstituted amino group or a substituted or unsubstituted alkoxy group, and V may form a condensed ring together with the benzene ring; and A represents a substitutent which may be a ring fused to the benzene ring; or formula (II): 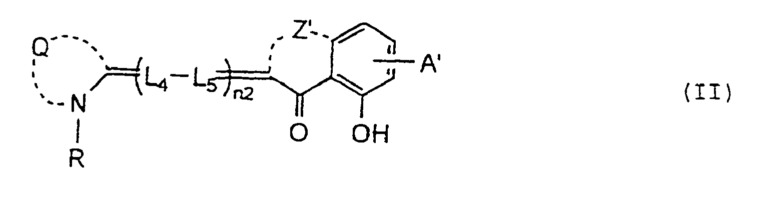 wherein Z' has the same meaning as Z; L₄ and L₅ have the same meaning as L₁, L₂ and L₃; n2 represents an integer of 1 to 4; Q represents an atomic group necessary to complete a 5- or 6-membered hetero ring together with the nitrogen atom, the hetero ring may have a substituent and further may be a condensed ring; R represents an alkyl group; and A' has the same meaning as A.
(2) The photoelectric conversion device according to the above item (1), wherein said hetero ring completed by Q in formula (II) comprises a benzothiazole nucleus, a benzoxazole nucleus, a 2-quinoline nucleus, a 4-quinoline nucleus or an indolenine nucleus.
(3) The photoelectric conversion device according to the above item (1) or (2), wherein the acidic nucleus comprising the ring completed by Z in formula (I) or Z' in formula (II) is one of the following structures (a) to (e), which may have one or more substituents. 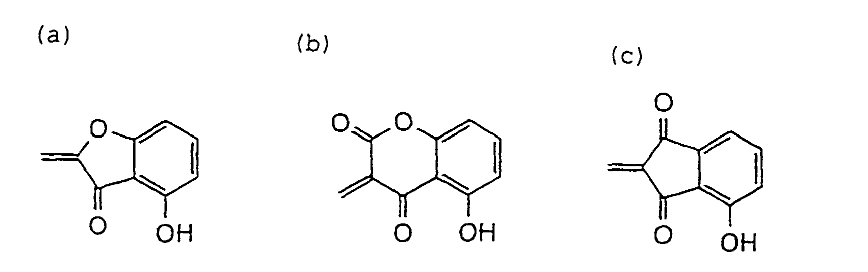 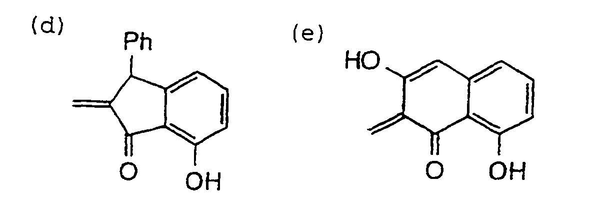
(4) The photoelectric conversion device according to any one of the above items (1) to (3), wherein said semiconductor particles are titanium dioxide particles.
(5) A photoelectric cell having the photoelectric conversion device according to any one of the above items (1) to (4).

### BRIEF DESCRIPTION OF THE DRAWING

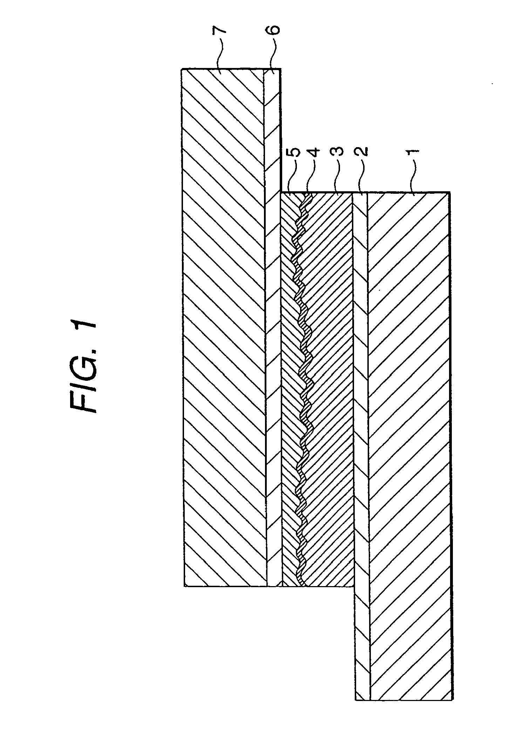

Fig. 1 is a schematic cross section of the photoelectric cell prepared in the Examples.

### DETAILED DESCRIPTION OF THE INVENTION

Dyes represented by formulas (I) and (II) are described in detail below.

In formula (I), Z represents a single bond or an atomic group necessary to complete a 5- to 9-membered ring. The atomic group is made of atoms selected from hydrogen, carbon, oxygen, nitrogen, and sulfur. Where Z is a single bond, it forms a 4-membered ring. The ring completed by Z is preferably a 4-membered ring or a 5- or 6-membered ring composed of atoms selected from hydrogen, carbon, and oxygen. It is still preferred for the acidic nucleus comprising the ring completed by Z to have any one of the structures (a) to (e) shown below.

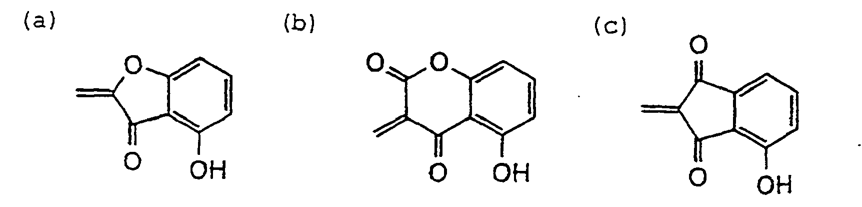

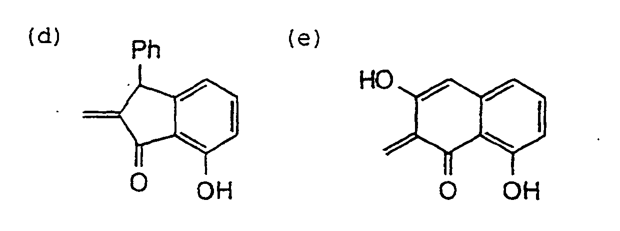

The structures (a) to (e) may have a substituent(s). Examples of the substituents are the same as those described later as the substituent represented by A.

L₁, L₂, and L₃ each represent a nitrogen atom or a substituted or unsubstituted methine group, preferably an unsubstituted methine group. n1 represents 0, 1 or 2, preferably 0. Substituents on a methine group include an alkyl group which preferably contains 1 to 5 carbon atoms, particularly 1 to 3 carbon atoms, an alkenyl group which preferably contains 2 to 6 carbon atoms, particularly 2 to 4 carbon atoms, an aryl group which preferably contains 6 to 12 carbon atoms, particularly 6 to 8 carbon atoms, a halogen atom, and a hetero ring.

V represents a substituted or unsubstituted amino group or a substituted or unsubstituted alkoxy group, or V may form a ring condensed with the benzene ring. The alkoxy group preferably has 1 to 6, particularly 1 to 3 carbon atoms, including a methoxy group, an ethoxy group, and a propoxy group. Substituents on the amino or alkoxy group include an alkyl group which preferably has 1 to 8, particularly 1 to 4, carbon atoms, an aryl group which preferably has 6 to 12, particularly 6 to 8, carbon atoms, a carboxyl group, a sulfo group, a hydroxyl group, and a halogen atom. V preferably represents a substituted or unsubstituted amino group, with a diarylamino group being particularly preferred.

A represents a substitutent which may be a ring fused to the benzene ring to which it is bonded. Examples of A include a hydroxyl group, an alkyl group which preferably contains 1 to 5, particularly 1 to 3, carbon atoms, an aryl group which preferably contains 6 to 12, particularly 6 to 8, carbon atoms, an alkoxy group which preferably contains 1 to 6, particularly 1 to 3, carbon atoms, an amino group, a carboxyl group, a sulfo group, and a halogen atom.

In formula (II), Z' has the same meaning as Z. The preference for Z applies to Z'. L₄ and L₅ have the same meaning as L₁, L₂, and L₃. The preference for L₁, L₂ and L₃ applies to L₄ and L₅. n2 is an integer of from 1 to 4. n2 is preferably 1 or 2. Q represents an atomic group necessary to complete a 5- or 6-membered nitrogen-containing hetero ring. Q may have a substituent(s) and may be a condensed ring.

Examples of the nucleus of the nitrogen-containing hetero ring completed by Q preferably includes a benzothiazole nucleus, a benzoxazole nucleus, a benzoselenazole nucleus, a benzotellurazole nucleus, a 2-quinoline nucleus, a 4-quinoline nucleus, a benzimidazole nucleus, a thiazoline nucleus, an indolenine nucleus, an oxadiazole nucleus, a thiazole nucleus, and an imidazole nucleus. Still preferred are a benzothiazole nucleus, a benzoxazole nucleus, a benzimidazole nucleus, a benzoselenazole nucleus, a 2-quinoline nucleus, a 4-quinoline nucleus, and an indolenine nucleus. Particularly preferred are a benzothiazole nucleus, a benzoxazole nucleus, a 2-quinoline nucleus, a 4-quinoline nucleus, and an indolenine nucleus. Substituents which may be on these rings include a carboxyl group, a phospho group, a sulfo group, a halogen atom (i.e., F, Cl, Br or I), a cyano group, an alkoxy group (e.g., methoxy, ethoxy, methoxyethoxy), an aryloxy group (e.g., phenoxy), an alkyl group (e.g., methyl, ethyl, cyclopropyl, cyclohexyl, trifluoromethyl, methoxyethyl, allyl, benzyl), an alkylthio group (e.g., methylthio, ethylthio), an alkenyl group (e.g., vinyl, 1-propenyl), and an aryl group (e.g., phenyl, thienyl, toluyl, chlorophenyl).

A' has the same meaning as A. The preference for A applies to A'.

Specific examples of the compounds represented by formula (I) or (II) are shown below, but are not limited thereto.

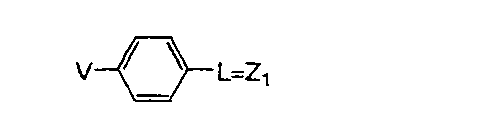

| | | | |
|---|---|---|---|
| Compound | V | L | Z₁ |
| S-1 | -NPh₂ | -CH= | 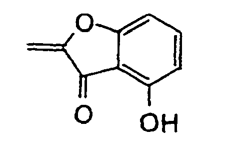 |
| S-2 | -NPh₂ | -N= | " |
| S-3 | -OCH₃ | -CH= | " |
| S-4 | -NEt₂ | -CH= | 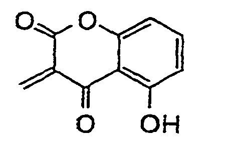 |
| S-5 | -NEt₂ | -N= | " |
| S-6 | -NPh₂ | -CH= | 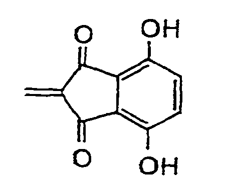 |
| S-7 | -NPh₂ | -CH=CH-CH= | 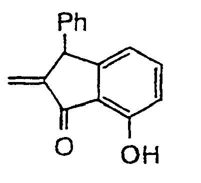 |

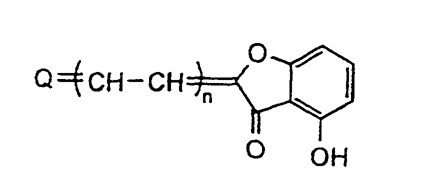

| Compound | 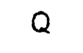 | n |
|---|---|---|
| S-8 | 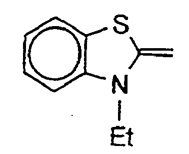 | 1 |
| S-9 | 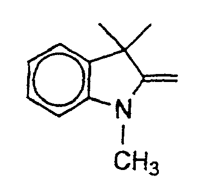 | 1 |
| S-10 | 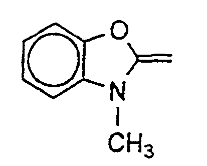 | 1 |
| S-11 | 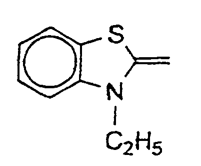 | 2 |
| S-12 | 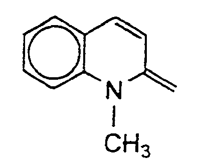 | 1 |
| S-13 | 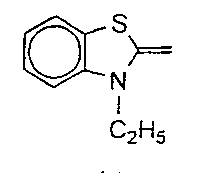 | 3 |

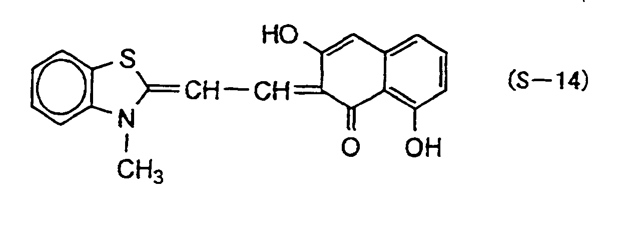

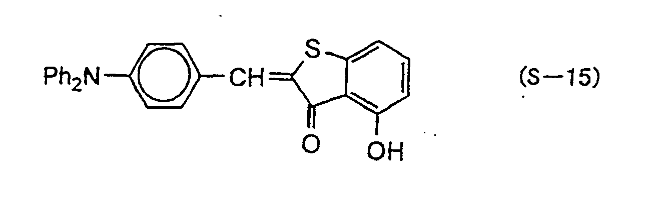

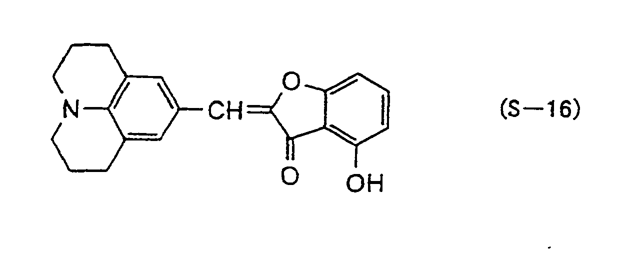

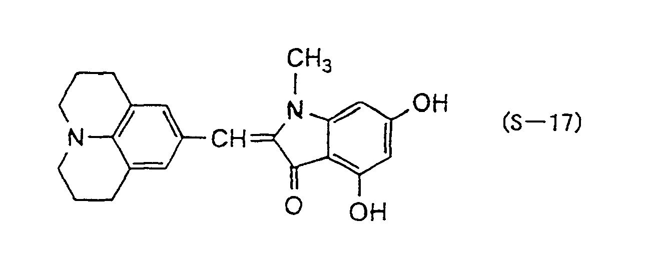

Synthesis Examples of the compounds (I) and (II) are shown below.

### SYNTHESIS EXAMPLE 1

### Synthesis of Compound (S-1):

Compound (S-1) can be synthesized in accordance with the following scheme.

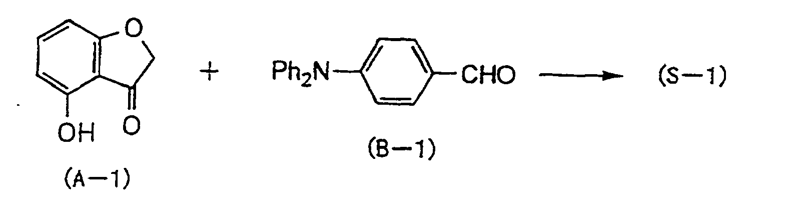

In a 20% potassium hydroxide aqueous solution was dissolved 0.15 g of compound (A-1), and an ethanolic solution of 0.3 g of compound (B-1) was added thereto, followed by cooling with ice. The crystals thus precipitated were collected by filtration by suction and purified by column chromatography on Sephadex to give 0.4 g of compound (S-1).
λₘₐₓ = 480 nm (ε = 55000), in methanol.

### SYNTHESIS EXAMPLE 2

### Synthesis of Compound (S-8):

Compound (S-8) can be synthesized in accordance with the following scheme.

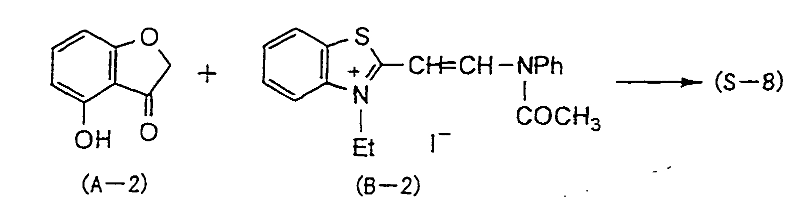

In 4 ml of ethanol were dissolved 0.12 g of compound (A-2), 0.27 g of compound (B-2), and 0.1 ml of triethylamine, and the solution was heated under reflux for 5 minutes. The reaction mixture was concentrated, and the residue was purified by silica gel column chromatography to give 0.14 g of compound (S-8).
λₘₐₓ = 500 nm (ε = 40000), in methanol.

The constitutions of the photoelectric conversion device and photoelectric cell and the materials for use therein are described in detail below.

The dye-sensitized photoelectric conversion device according to the invention comprises an electrically conductive support, and a dye-sensitized semiconductor layer (photosensitive layer), a charge transporting layer and a counter electrode, each provided on the conductive support. The conductive support having the semiconductor layer functions as a work electrode. The photoelectric cell according to the invention is a practical application of the photoelectric conversion device for use as a battery working in an external circuit.

The photosensitive layer is designed to fit for the end use and can have either a single layer structure or a multilayer structure. Light having entered the photosensitive layer excites the dye. The excited dye has high energy electrons, which are handed over from the dye to the conduction band of the semiconductor particles and diffused to reach the conductive support. Meanwhile the dye molecules are converted into an oxidized state. In a photoelectric cell, the electrons on the conductive support return to the oxidized dye through the counter electrode and the charge transporting layer thereby to regenerate the dye while working in the external circuit. The semiconductor layer acts as a negative electrode of the cell. The components of the individual layers constituting the device may be diffused and mixed mutually at their boundaries, for example, the boundary between the conductive layer (hereinafter described) of the conductive support and the photosensitive layer, the boundary between the photosensitive layer and the charge transporting layer, and the boundary between the charge transporting layer and the counter electrode.

The semiconductor serves as a photoreceptor that absorbs light to separate charges and generate electrons and positive holes. In the dye-sensitized semiconductor, the task of light absorption and generation of electrons and holes is chiefly performed by the dye, and the semiconductor plays a role in accepting and transmitting the electrons.

The semiconductor which can be used in the invention includes element semiconductors, e.g., Si or Ge, compound semiconductors, such as metal chalcogenides (e.g., oxides, sulfides and selenides) and semiconductors having a perovskite structure. The metal chalcogenides include an oxide of titanium, tin, zinc, iron, tungsten, zirconium, hafnium, strontium, indium, cerium, yttrium, lanthanum, vanadium, niobium or tantalum; a sulfide of cadmium, zinc, lead, silver, antimony or bismuth; a selenide of cadmium or lead; and cadmium telluride. Other compound semiconductors include a phosphide of zinc, gallium, indium or cadmium, gallium arsenide, copper indium selenide, and copper indium sulfide. The perovskite semiconductors include strontium titanate, calcium titanate, sodium titanate, barium titanate, and potassium niobate.

Preferred semiconductors for use in the invention include Si, TiO₂, SnO₂, Fe₂O₃, WO₃, ZnO, Nb₂O₅, CdS, ZnS, PbS, Bi₂S₃, CdSe, CdTe, GaP, InP, GaAs, CuInS₂, and CuInSe₂. Still preferred are TiO₂, ZnO, SnO₂, Fe₂O₃, WO₃, Nb₂O₅, CdS, PbS, CdSe, InP, GaAs, CuInS₂, and CuInSe₂. TiO₂ and Nb₂O₅ are particularly preferred. TiO₂ is the most preferred.

The semiconductor may be a single crystal or polycrystalline. A single crystal is preferred for conversion efficiency, while a polycrystalline semiconductor is preferred from the standpoint of production cost, supply of raw materials, and an energy payback time. Finely particulate semiconductors having a particle size on the order of nanometers to microns are particularly preferred. The particulate semiconductors preferably have an average primary particle size of 5 to 200 nm, particularly 8 to 100 nm, in terms of a projected area diameter. The semiconductor particles in a dispersed state (secondary particles) preferably have an average particle size of 0.01 to 100 µm.

Semiconductor particles of two or more kinds having different size distributions can be used as a mixture. In this case, the average size of smaller particles is preferably 5 nm or less. For the purpose of scattering incident light to improve the rate of capturing light, large semiconductor particles about 300 nm in size may be used in combination.

The particulate semiconductor is preferably prepared by a sol-gel process described, e.g., in Sumio Sakubana, Sol-gel- hono kagaku, Agune Shofusha (1988) and Gijutsu Joho Kyokai, Sol-gel-ho niyoru hakumaku coating gijutsu (1995), and a gel-sol process described in Tadao Sugimoto, Materia, vol. 35, No. 9, pp. 1012-1018, "Shin goseiho gel-sol-ho niyoru tanbunsan ryushino goseito size keitai seigyo" (1996). The process for preparing an oxide developed by Degussa AG which comprises pyrogenically hydrolyzing a metal chloride in an oxyhydrogen flame is also preferred.

For preparation of titanium oxide particles, a sulfuric acid process and a chlorine process described in Manabu Seino, Sanka titan busseito ohyogijutu, Gihodo (1997) are also employable for preference in addition to the above-described sol-gel process, gel-sol process and pyrogenic flame hydrolysis. Of the available sol-gel processes for preparing titanium oxide particles, particularly preferred are the process described in Barbe, et al, Journal of American Ceramic Society, vol. 80, No. 12, pp. 3157-3171 (1997) and the process described in Burnside, et al., Chemical Materials, vol. 10, No. 9, pp. 2419-2425 (19**).

The electrically conductive support includes a support made of a conductive material, such as metal, and a support comprising a nonconductive substrate made of glass or plastics having on the surface thereof a conductive layer. Preferred conductors for use in the latter type of conductive supports include metals (e.g., platinum, gold, silver, copper, aluminum, rhodium, and indium), carbon, and electrically conductive metal oxides (e.g., indium tin oxide and fluorine-doped tin oxide). The conductive layer preferably has a thickness of about 0.02 to 10 µm.

The conductive support preferably has as low a surface resistance as possible. A desirable surface resistance is 100 Ω/square or smaller, particularly 40 Ω/square or smaller. While not limiting, the practical minimal surface resistance is generally about 0.1 Ω/square.

It is preferred that the conductive support be substantially transparent to light. The term "substantially transparent" is intended to mean that the light transmission is at least 10%, preferably 50% or more, still preferably 70% or more. A transparent substrate such as glass or plastic, having a conductive metal oxide layer coated thereon is preferred as a transparent support. Of the above conductive supports particularly preferred is a conductive glass support obtained by depositing a conductive layer comprising fluorine-doped tin dioxide on a transparent substrate made of inexpensive soda-lime float glass. For the manufacture of inexpensive flexible photoelectric conversion devices or solar cells, a support comprising a transparent polymer film having the above-described conductive layer is suitable. Useful transparent polymers include tetraacetylcellulose (TAC), polyethylene terephthalate (PET), polyethylene naphthalate (PEN), syndiotactic polystyrene (SPS), polyphenylene sulfide (PPS), polycarbonate (PC), polyacrylate (PAr), polysulfone (PSF), polyester sulfone (PES), polyether-imide (PEI), cyclic polyolefins, and brominated phenoxy resins. The coated amount of the conductive metal oxide is preferably 0.01 to 100 g per m² of a glass or plastic substrate. The transparent conductive support is preferably used in such a manner that incident light enters from the support (substrate) side.

In order to decrease the resistance of the transparent conductive support, it is preferred to use a metal lead, which is preferably made of aluminum, copper, silver, gold, platinum, nickel, etc., with an aluminum lead or a silver lead being particularly preferred. The metal lead is preferably formed on the transparent substrate by vacuum evaporation, sputtering or a like deposition technique, on which a transparent conductive layer of fluorine-doped tin oxide or ITO is provided. It is also preferred that the transparent conductive layer be provided on the transparent substrate, on which the metal lead be then formed. Reduction in incident light quantity due to the metal lead is preferably 1 to 10%, preferably 1 to 5%.

The semiconductor particles are applied to the conductive support by, for example, a method comprising coating the conductive support with a dispersion or colloidal solution of the semiconductor particles or the aforementioned sol-gel process, and the like. Film formation in a wet system is relatively advantageous, taking into consideration suitability to large-scale production of a photoelectric conversion device, controllability of liquid physical properties, and adaptability to various supports. Film formation in a wet system is typically carried out by coating or printing.

A dispersion of the semiconductor particles is prepared by the above-mentioned sol-gel process, a method comprising grinding a semiconductor in a mortar, or a method comprising wet grinding a semiconductor in a mill. A synthetic semiconductor as precipitated in a solvent in the form of fine particles can also be used as such. Useful dispersing media include water and various organic solvents, such as methanol, ethanol, isopropyl alcohol, dichloromethane, acetone, acetonitrile, and ethyl acetate. In preparing a dispersion, a polymer, a surface active agent, an acid, a chelating agent, and the like may be added as a dispersant if desired.

Wet coating techniques include application methods such as roll coating and dip coating, metering methods such as air knife coating or blade coating, and application methods combined with metering such as wire bar coating (JP-B-58-4589), slide hopper coating (U.S. Patents 2,681,294, 2,761,419, and 2,761,791), extrusion coating, and curtain coating. General-purpose spin coating or spraying techniques are also suitable. Wet printing techniques include letterpress printing, offset printing, gravure printing, intaglio printing, rubber plate printing, and screen printing. A suitable film formation system is selected from among the above-enumerated techniques in accordance with the liquid viscosity and a desired wet thickness.

The liquid viscosity is largely dependent on the kind and the dispersibility of the semiconductor particles, the solvent, and additives such as a surface active agent and a binder. In order to form a uniform film, extrusion coating or casting is fit for a high viscous liquid (e.g., 0.01 to 500 Poise), while slide hopper coating, wire bar coating or spin coating is suited for a low viscous liquid (e.g., 0.1 Poise or lower). A low viscous liquid could be applied by extrusion coating where it is to be applied to some coating weight. Screen printing, as is often used in applying a high-viscosity paste of semiconductor particles, can be used as well. Thus, a suitable wet process for film formation can be selected in accordance with such parameters as the liquid viscosity, the coating weight, the type of the support, the speed of application, and so forth.

The semiconductor layer does not need to be a single layer. Two or more layers different in particle size of semiconductor particles, in kind of semiconductors or in composition as for the binder or additives can be provided. In case where single operation of application is insufficient for giving a desired thickness, multilayer coating is effective. Extrusion coating or slide hopper coating is suitable for multilayer coating. Multilayer coating can be carried out simultaneously or by successively repeating the coating operation several times or more than ten times. Screen printing is also preferably applicable to successive multilayer coating.

In general, as the thickness of the particulate semiconductor layer increases, the amount of the dye held per unit projected area increases to show an increased rate of capturing light, but the distance of diffusion of generated electrons also increases, which results in an increased loss due to re-coupling of charges. Accordingly, there is a favorable thickness range for the particulate semiconductor layer, which is typically from 0.1 to 100 µm. Where the device is used as a photoelectric cell, a favorable thickness is 1 to 30 µm, particularly 2 to 25 µm. The coating weight of the semiconductor particles is preferably 0.5 to 400 g, still preferably 5 to 100 g per m² of the substrate.

It is preferred that the semiconductor particles applied to the support be heated to bring them into electronic contact with each other, to improve film strength, and to improve adhesion to the support. A preferred heating temperature is 40°C or higher and lower than 700°C, particularly from 100 to 600°C. The heating time is usually from about 10 minutes to about 10 hours. Where a support having a low melting point or a softening point, such as a polymer film, is used, high-temperature treatment which would deteriorate the support should be avoided. Also for the economical consideration, the heating temperature is preferably as low as possible. The heating temperature can be lowered by using the above-mentioned small semiconductor particles having a diameter of up to 5 nm in combination or by conducting the heat treatment in the presence of a mineral acid.

For the purpose of increasing the surface area of the semiconductor particles and of increasing the purity in the vicinities of the semiconductor particles thereby to improve electron injection efficiency from the dye to the semiconductor particles, the heat-treated particulate semiconductor layer can be subjected to chemical plating with a titanium tetrachloride aqueous solution or electrochemical plating with a titanium trichloride aqueous solution.

It is preferable for the semiconductor particles to have a large surface area so that they may adsorb as large an amount of a dye as possible. The surface area of the semiconductor particles in the state applied to the conductive support is preferably 10 times or more, still preferably 100 times or more, the projected area thereof. The practical upper limit of the surface area is, while not limited, about 1000 times the projected area.

In the present invention, two or more kinds of dyes can be used in combination so as to broaden the wavelength region of photoelectric conversion and to increase the conversion efficiency. The dyes to be combined and their ratio can be selected in conformity with the wavelength region and the intensity distribution of a light source to be used. Two or more kinds of the dyes of formula (I) or (II) according to the invention may be combined, or the dyes of the invention and other known polymethine dyes or metal complex dyes (e.g., Ru complexes) may be combined.

Adsorption of the dyes onto semiconductor particles is usually effected by dipping well-dried work electrode having semiconductor particles in a dye solution (e.g., immersion, dip coating, roll coating or air knife coating) or coating the semiconductor layer with a dye solution (e.g., wire bar coating, slide hopper coating, extrusion coating, curtain coating, spin coating, spraying, letterpress printing, offset printing, gravure printing, or screen printing). In case of immersion, the dye adsorption may be either at room temperature or under reflux as taught in JP-A-7-249790.

The solvent for the dye solution is selected appropriately according to the solubility of the dye. Useful solvents are water, alcohols (e.g., methanol, ethanol, t-butanol and benzyl alcohol), nitriles (e.g., acetonitrile, propionitrile and 3-methoxypropionitrile), nitromethane, halogenated hydrocarbons (e.g., dichloromethane, dichloroethane, chloroform, and chlorobenzene), ethers (e.g., diethyl ether and tetrahydrofuran), dimethyl sulfoxide, amides (e.g., N,N-dimethylformamide and N,N-dimethylacetamide), N-methylpyrrolidone, 1,3-dimethylimidazolidinone, 3-methyloxazolidinone, esters (e.g., ethyl acetate and butyl acetate), carbonic esters (e.g., diethyl carbonate, ethylene carbonate, and propylene carbonate), ketones (e.g., acetone, 2-butanone, and cyclohexanone), hydrocarbons (e.g., hexane, petroleum ether, benzene, and toluene), and mixtures thereof.

As previously described with regard to the formation of the particulate semiconductor layer, extrusion coating and various printing methods are fit for a high viscous dye solution (e.g., 0.01 to 500 P), while slide hopper coating, wire bar coating and spin coating are suited for a low viscous dye solution (e.g., 0.1 P or lower) to form a uniform film. In this way, an appropriate technique for dye adsorption is to be selected according to such parameters as the viscosity of the dye solution, the coating weight, the kind of the support, the speed of application, and the like. Taking the suitability to large-scale production, the time required for dye adsorption after dye application is conveniently as short as possible.

The above-described heat treatment of the semiconductor layer before dye adsorption is also favorable for increasing the amount of the dyes adsorbed. In this case, it is preferred that the dyes be quickly adsorbed into the heated semiconductor layer while it is between 40°C and 80°C so as to prevent water from being adsorbed to the semiconductor particles.

In order to obtain a sufficient sensitizing effect, the dyes are preferably adsorbed in a total amount of 0.01 to 100 mmol per m² of the support and 0.01 to 1 mmol per gram of the semiconductor particles. With too small a total amount of the dyes, the sensitizing effect would be insufficient. If the dyes are used in too large a total amount, the non-adsorbed dyes will float only to reduce the sensitizing effect.

A colorless compound may be adsorbed together with the dyes so as to lessen the interaction among dye molecules, such as association. Hydrophobic compounds such as carboxyl-containing steroid compounds (e.g., cholic acid) can be used for this purpose. Ultraviolet absorbers may be used in combination.

Because the dyes remaining unadsorbed causes disturbances of device performance, they should be washed away immediately after adsorption. Washing is conveniently carried out in a wet washing tank with an organic solvent, such as a polar solvent (e.g., acetonitrile) or an alcohol. If desired, the surface of the semiconductor particles can be treated with an amine after dye adsorption so as to accelerate removal of the unadsorbed dyes. Preferred amines include pyridine, 4-t-butylpyridine, and polyvinylpyridine. The amine can be used as such where it is liquid, or as dissolved in an organic solvent.

The charge transporting layer and the counter electrode are described in detail below.

The charge transporting layer is a layer comprising a charge transporting material having a function of replenishing oxidized dyes with electrons. The charge transporting material which can be used in the invention typically includes a solution of a redox ion system in an organic solvent (i.e., an electrolytic solution), a gel electrolyte comprising a polymer matrix impregnated with a solution of a redox ion system in an organic solvent, and a molten salt containing a redox ion system. A solid electrolyte is also useful. In place of the charge transporting materials comprising ions, solid materials in which carriers migrate to serve for electric conduction, i.e., electron transporting materials or hole-transporting materials, can also be used.

The electrolytic solution used in the invention preferably comprises an electrolyte, a solvent, and additives. The electrolyte includes combinations of I₂ and an iodide (for example, a metal iodide, such as LiI, NaI, KI, CsI or CaI₂, and an iodine salt of a quaternary ammonium compound, such as a tetraalkylammonium iodide, pyridinium iodide and imidazolium iodide); combinations of Br₂ and a bromide (for example, a metal bromide, such as LiBr, NaBr, KBr, CsBr or CaBr₂, and a bromine salt of a quaternary ammonium compound, such as a tetraalkylammonium bromide or pyridinium bromide); metal complexes, such as a ferrocyananate-ferricyanate system or a ferrocene-ferricinium ion system; sulfur compounds, such as poly(sodium sulfite) and an alkylthiol-alkyl disulfide; viologen dyes; hydroquinone-quinone; and the like. Preferred of them are combinations of I₂ with LiI or with an iodine salt of a quaternary ammonium compound, such as pyridinium iodide or imidazolium iodide. These electrolytes can be used either individually or as a mixture thereof. Molten salts (salts which take a molten state at room temperature) described in EP 718288, WO95/18456, J. Electrochem. Soc., vol. 143, No. 10, p. 3099 (1996), and Inorg. Chem., vol. 35, pp. 1168-1178 (1996) are also useful as an electrolyte. In using a molten salt, a solvent is unnecessary.

A suitable electrolyte concentration is 0.1 to 15 M, preferably 0.2 to 10 M. Where iodine is added to the electrolyte, a preferred iodine concentration is 0.01 to 0.5 M.

It is preferred for the solvent dissolving the electrolyte to have a low viscosity and a high dielectric constant thereby to manifest excellent ion conductivity. To have a low viscosity leads to an improvement in ion mobility. To have a high dielectric constant brings about an increase in effective carrier concentration. Solvents suitable from this viewpoint include carbonate compounds, such as ethylene carbonate and propylene carbonate; heterocyclic compounds, such as 3-methyl-2-oxazolidinone; ether compounds, such as dioxane and diethyl ether; acyclic ethers, such as ethylene glycol dialkyl ethers, propylene glycol dialkyl ethers, polyethylene glycol dialkyl ethers, and polypropylene glycol dialkyl ethers; alcohols, such as methanol, ethanol, ethylene glycol monoalkyl ethers, propylene glycol monoalkyl ethers, polyethylene glycol monoalkyl ethers, and polypropylene glycol monoalkyl ethers; polyhydric alcohols, such as ethylene glycol, propylene glycol, polyethylene glycol, polypropylene glycol, and glycerol; nitrile compounds, such as acetonitrile, glutaronitrile, methoxyacetonitrile, propionitrile, and benzonitrile; aprotic polar solvents, such as dimethyl sulfoxide and sulfolane; and water.

The electrolyte can contain a basic compound, such as t-butylpyridine, 2-picoline, and 2,6-lutidine, as disclosed in J. Am. Ceram. Soc., vol. 80, No. 12, pp. 3157-3171 (1997). A preferred concentration of the basic compound is 0.05 to 2 M.

A liquid electrolyte can be solidified to gel by addition of a polymer, addition of an oil gelling agent, polymerization of a polyfunctional monomer, crosslinking of a polymer, or a like technique. Polymers which can be added to cause the electrolyte to gel include the compounds described in J.R. MacCallum and C.A. Vincent, Elsevier Applied Science, "Polymer Electrolyte Reviews-1 and 2". Polyacrylonitrile and polyvinylidene fluoride are particularly preferred.

The electrolyte may be replaced with an organic and/or an inorganic hole-transporting material. Useful hole-transporting materials include aromatic amine compounds, polythiophene compounds, polypyrrole compounds, polyacetylene compounds, polyaniline compounds, and polytoluidine compounds. As taught in Nature, vol. 395, pp. 583-585 (Oct. 8, 1998), a compound containing a cationic radical, such as tris(4-bromophenyl)aluminum hexachloroantimonate, can be added to the organic hole-transporting material so as to control the dopant level, or a salt such as Li[(CF₃SO₂)₂N] can be added to control the potential on the oxide semiconductor surface (i.e., compensation of a space charge layer).

The organic hole-transporting material can be introduced into the inside of the electrode by vacuum evaporation, casting, coating, spin coating, dipping, electrolytic polymerization, photoelectrolytic polymerization, and the like. Where the hole-transporting material is used in place of an electrolytic solution, it is preferred to provide a titanium dioxide thin layer as an undercoat for preventing a shot circuit by, for example, spray pyrolysis as described in Electrochim. Acta, vol. 40, pp. 643-652 (1995).

Where an inorganic solid compound is used in place of an electrolyte, copper iodide (p-CuI) (see J. Phys. D:Appl Phys., vol. 31, pp. 1492-1496 (1998)), copper thiocyanide (see Thin Solid Films, vol. 261, pp. 307-310 (1995), J. Appl. Phys., vol. 80, No. 8, pp. 4749-4754 (Oct. 15, 1996), Chem. Mater., vol. 10, pp. 1501-1509 (1998), and Semicond. Sci. Technol., vol. 10, pp. 1689-1693 (19**)), etc. is introduced into the inside of the electrode by means of casting, coating, spin coating, dipping, electrolytic plating, and the like.

There are two conceivable methods of forming a charge transporting layer. One comprises adhering a counter electrode to the dye-sensitized semiconductor layer and penetrating a liquid charge transporting material into the gap therebetween. The other comprises forming a charge transporting layer on the dye-sensitized semiconductor layer and then providing a counter electrode thereon. The former method can be effected by an ambient pressure process which makes use of capillarity by, for example, soaking or a vacuum process in which a gas phase is displaced with a liquid phase under reduced pressure.

The latter method includes various embodiments. Where the charge transporting layer is of a wet system, a counter electrode is provided thereon while the layer is wet, and the edges call for a leakproof measure. In the case of a gel electrolyte, a wet electrolyte as applied may be solidified by, for example, polymerization. In this case, the solidified gel electrolyte can be dried and fixed before a counter electrode is provided. A wet organic hole-transporting material or a gel electrolyte as well as an electrolytic solution can be applied in the same manner as for the formation of the particulate semiconductor-containing layer or for dye adsorption, i.e., immersion, roll coating, dip coating, air knife coating, extrusion coating, slide hopper coating, wire bar coating, spin coating, spraying, casting, and various printing methods. A solid electrolyte or a solid hole-transporting material can be applied by dry film forming techniques, such as vacuum evaporation or CVD.

Considering adaptability to large-scale production, an electrolytic solution or a wet hole-transporting material that cannot be solidified can be dealt with by sealing the edges immediately after application. In the case of a hole-transporting material that can be solidified, it is preferred for scaling-up that the film formed in a wet system be solidified by photopolymerization or heat-induced radical polymerization, etc. before a counter electrode is provided thereon. In this manner, the method of forming a charge transporting layer can be chosen appropriately according to the liquid physical properties or processing conditions.

The water content of the charge transporting layer is preferably 10,000 ppm or less, still preferably 2,000 ppm or less, particularly preferably 100 ppm or less.

In a photoelectric cell using the photoelectric conversion device, the counter electrode functions as a positive electrode. The counter electrode usually comprises a substrate having thereon a conductive layer, such as the one used for the semiconductor electrode (work electrode), but the substrate is not always required as far as sufficient strength or tight seal is secured. Conductive materials of choice for the counter electrode include metals (e.g., platinum, gold, silver, copper, aluminum, rhodium, and indium), carbon, and conductive metal oxides (e.g., indium-tin complex oxide and fluorine-doped tin oxide). Suitable counter electrodes include a glass or plastic substrate having a metal or a conductive oxide deposited thereon and a thin metal film. While not limiting, the counter electrode preferably has a thickness of 3 nm to 10 µm. In particular, a metallic counter electrode preferably has a thickness of 5 µm or smaller, particularly 5 nm to 3 µm.

At least one of the conductive support of the work electrode and the counter electrode must be substantially transparent so that incident light can reach the photosensitive layer. It is preferred for the photoelectric cell of the invention that the conductive support of the work electrode be transparent so that light may be incident upon this side. In this case, it is a preferred embodiment that the counter electrode has light reflecting properties.

As mentioned with respect to formation of the charge transporting layer, the counter electrode is provided either on the charge transporting layer or directly on the particulate semiconductor-containing layer. In either case, the counter electrode can be provided by coating, laminating, vacuum evaporation, press bonding, or the like method as selected appropriately according to the kind of the counter electrode or the kind of the charge transporting layer. For example, a support having a conductive layer of the above-described conductive material formed by coating, vacuum evaporation or CVD can be stuck on the charge transporting layer or the particulate semiconductor-containing layer. Where the charge transporting layer is solid, the above-described conductive material is applied thereon by coating, plating, PVD, CVD, or a like technique.

If necessary, additional functional layers, such as a protective layer and an antireflection layer, can be formed on the conductive support of the work electrode and/or the counter electrode. Where a plurality of additional layers having the respective functions are to be provided, while they can be formed either simultaneously or successively, simultaneous coating is preferred for productivity. Simultaneous coating is conveniently carried out by a slide hopper system or extrusion coating in view of productivity and uniformity of the film formed. Depending on the material, these functional layers may be provided by vacuum evaporation or press bonding.

The photoelectric cell of the invention preferably has its sides sealed with a polymer, an adhesive, etc. to prevent deterioration by oxidation or volatilization of the volatile matter contained therein.

The present invention will now be illustrated in greater detail with reference to the following Examples, but the invention should not be construed as being limited thereto. Unless otherwise noted, all the percents are by weight.

### EXAMPLE 1

### 1) Preparation of titanium dioxide-containing coating composition

A titanium dioxide dispersion having a concentration of 11% was prepared in accordance with the method reported in Barbe, et al, J. Am. Ceram. Soc., vol. 80, No. 12 p. 3157 (1997), except that the autoclave temperature was set at 230°C. The average particle size of the dispersed titanium dioxide particles was about 10 nm. To the dispersion was added polyethylene glycol (molecular weight: 20,000, available from Wako Pure Chemical Ind., Ltd.) in an amount of 30% based on the titanium dioxide to prepare a coating composition.

### 2) Preparation of dye-sensitized TiO₂ electrode

The coating composition prepared in (1) above was applied to the conductive side of electrically conductive transparent glass having an fluorine-doped tin oxide coat (available from Nippon Sheet Glass Co., Ltd.; surface resistivity: about 10 Ω) with a doctor blade to a thickness of 140 µm. After drying at 25°C for 30 minutes, the coated glass substrate was baked in an electric muffle furnace (Model FP-32, manufactured by Yamato Kagaku) at 450°C for 30 minutes and cooled out of the furnace. The coating weight and thickness of the titanium dioxide layer were 15 g/m² and 10 µm, respectively.

The coated glass substrate was immersed in an ethanolic solution of 3 x 10⁻⁴ mol/l of the dye shown in Table 1 below for 3 hours. The dyed glass substrate was then immersed in 4-t-butylpyridine for 15 minutes, washed with ethanol, and dried spontaneously. The amount of the dye adsorbed was varied from 0.1 to 10 mmol/m² according to the dye.

### 3) Preparation of photoelectric cell

As shown in Fig. 1, the resulting dye-sensitized TiO₂ electrode substrate (2 cm x 2 cm) and a Pt-deposited glass substrate of the same size were brought into contact with the electrode layer 3 and the Pt deposit layer 6 facing each other. An electrolytic solution (a solution of 0.05 mol/l of iodine and 0.5 mol/l of lithium iodide in a 90:10 (by volume) mixed solvent of acetonitrile and N-methyl-2-oxazolidinone) was introduced into the gap between the two glass substrates by making use of capillarity so as to penetrate into the TiO₂ electrode. The resulting photoelectric cells were each composed of, in sequence, a conductive support (glass 1 with a transparent conductive layer 2), a TiO₂ electrode layer 3, a dye layer 4, an electrolyte layer 5, a Pt layer 6, and glass 7.

### 4) Measurement of photoelectric conversion wavelength and conversion efficiency

Photoelectric performance of the photoelectric cells prepared above was evaluated in terms of incident photon to current conversion efficiency (IPCE), which was measured with an IPCE measuring apparatus supplied by Optel Communications Inc. The wavelength at which each photoelectric cell manifests the maximum IPCE and the IPCE at that wavelength are shown in Table 1.

**TABLE 1**

| Dye | IPCEₘₐₓ Wavelength (nm) | IPCE (%) |
|---|---|---|
| S-1 | 500 | 75 |
| S-2 | 520 | 65 |
| S-3 | 460 | 70 |
| S-4 | 510 | 75 |
| S-5 | 540 | 65 |
| S-6 | 550 | 60 |
| S-7 | 620 | 62 |
| S-8 | 510 | 58 |
| S-14 | 520 | 65 |
| S-16 | 590 | 70 |

It is seen from Table 1 that any of the dyes has high photoelectric conversion characteristics.

According to the present invention, a photoelectric conversion device and a photoelectric cell exhibiting high conversion efficiency are provided by using economical organic dyes.

## Claims

1. A photoelectric conversion device comprising semiconductor particles sensitized with at least one dye represented by formula (I): 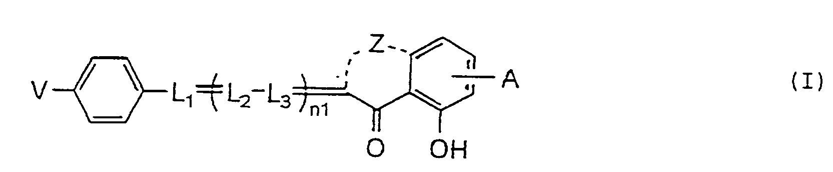 wherein Z represents a single bond or an atomic group necessary to complete a 5- to 9-membered ring, the atomic group being made up of atoms selected from hydrogen, carbon, oxygen, nitrogen and sulfur; L₁, L₂ and L₃ each represent a nitrogen atom or a substituted or unsubstituted methine group; n1 represents 0, 1 or 2; V represents a substituted or unsubstituted amino group or a substituted or unsubstituted alkoxy group, and V may form a condensed ring together with the benzene ring; and A represents a substitutent which may be a ring fused to the benzene ring; or formula (II): 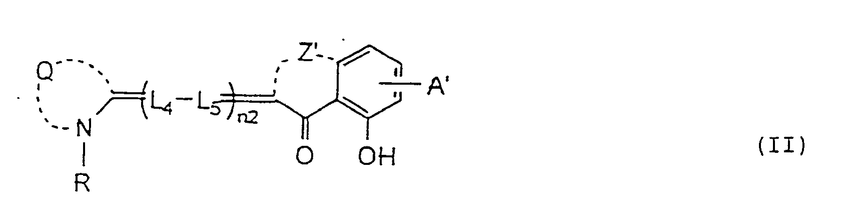 wherein Z' has the same meaning as Z; L₄ and L₅ have the same meaning as L₁, L₂ and L₃; n2 represents an integer of 1 to 4; Q represents an atomic group necessary to complete a 5- or 6-membered hetero ring together with the nitrogen atom, the hetero ring may have a substituent and further may be a condensed ring; R represents an alkyl group; and A' has the same meaning as A.

2. The photoelectric conversion device according to claim 1, wherein said hetero ring completed by Q in formula (II) comprises a benzothiazole nucleus, a benzoxazole nucleus, a 2-quinoline nucleus, a 4-quinoline nucleus or an indolenine nucleus.

3. The photoelectric conversion device according to claim 1 or 2, wherein the acidic nucleus comprising the ring completed by Z in formula (I) or Z' in formula (II) is one of the following structures (a) to (e), which may have one or more substituents.

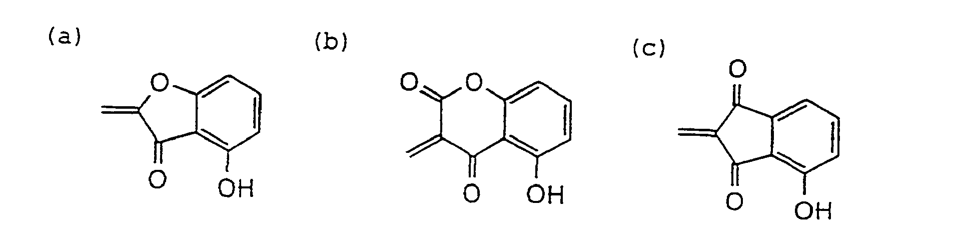

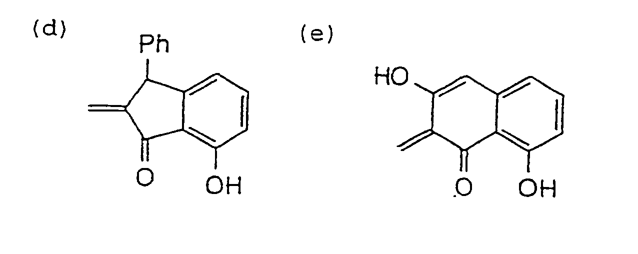

4. The photoelectric conversion device according to any one of claims 1 to 3, wherein said semiconductor particles are titanium dioxide particles.

5. A photoelectric cell having the photoelectric conversion device according to any one of claims 1 to 4.

## Patentansprüche

1. Photoelektrische Umwandlungsvorrichtung, umfassend Halbleiterteilchen, die mit mindestens einem Farbstoff sensibilisiert wurden, dargestellt durch die Formel (I): 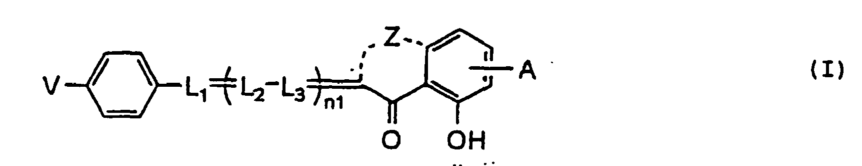 worin Z eine Einfachbindung oder eine Gruppe von Atomen ist, die erforderlich ist, um einen 5- bis 9-gliedrigen Ring zu vervollständigen, wobei die Gruppe von Atomen aus Atomen besteht, ausgewählt aus Wasserstoff, Kohlenstoff, Sauerstoff, Stickstoff und Schwefel; L₁, L₂ und L₃ bedeuten jeweils ein Stickstoffatom oder eine substituierte oder unsubstituierte Methingruppe; n1 ist 0, 1 oder 2; V ist eine substituierte oder unsubstituierte Aminogruppe oder eine substituierte oder unsubstituierte Alkoxygruppe, und wobei V zusammen mit dem Benzolring einen kondensierten Ring bilden kann; und A ist ein Substituent, der ein Ring sein kann, der an den Benzolring kondensiert ist; oder durch die Formel (II): 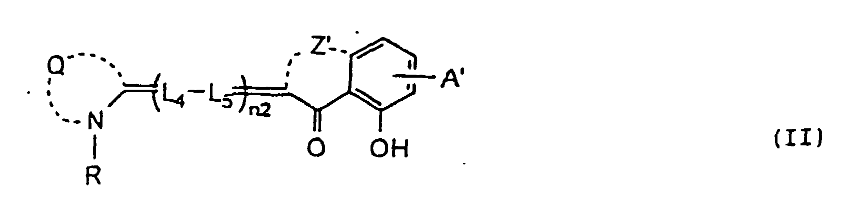 worin Z' die gleiche Bedeutung wie Z hat; L₄ und L₅ haben die gleiche Bedeutung wie L₁, L₂ und L₃; n2 ist eine ganze Zahl im Bereich von 1 bis 4; Q ist eine Gruppe von Atomen, die erforderlich ist, um zusammen mit dem Stickstoffatom einen 5-oder 6-gliedrigen Heteroring zu vervollständigen, wobei der Heteroring substituiert sein kann und wobei der Heteroring ein kondensierter Ring sein kann; R ist eine Alkylgruppe; und A' hat die gleiche Bedeutung wie A.

2. Photoelektrische Umwandlungsvorrichtung nach Anspruch 1, wobei der Heteroring, der in der Formel (II) durch Q vervollständigt wird, einen Benzothiazolkem, einen Benzoxazolkern, einen 2-Chinolinkern, einen 4-Chinolinkern oder einen Indoleninkem umfasst.

3. Photoelektrische Umwandlungsvorrichtung nach Anspruch 1 oder 2, wobei der saure Kern mit dem Ring, der in der Formel (I) durch Z oder in der Formel (II) durch Z' vervollständigt wird, durch eine der folgenden Strukturen (a) bis (e) dargestellt wird, die mit einem oder mehreren Substituenten substituiert sein können.

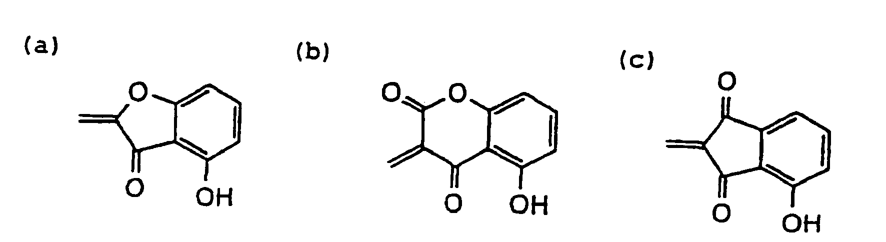

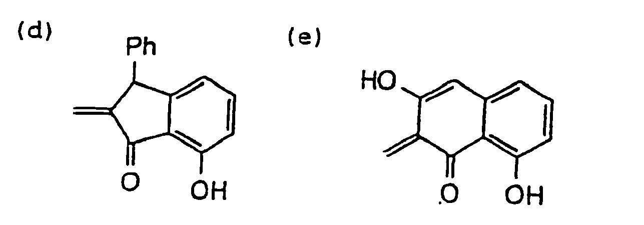

4. Photoelektrische Umwandlungsvorrichtung nach einem der Ansprüche 1 bis 3, wobei die Halbleiterteilchen Titandioxidteilchen sind.

5. Photoelektrische Zelle mit der photoelektrischen Umwandlungsvorrichtung nach einem der Ansprüche 1 bis 4.

## Revendications

1. Dispositif de conversion photoélectrique comprenant des particules semi-conductrices sensibilisées avec au moins un colorant représenté par la formule (I) : 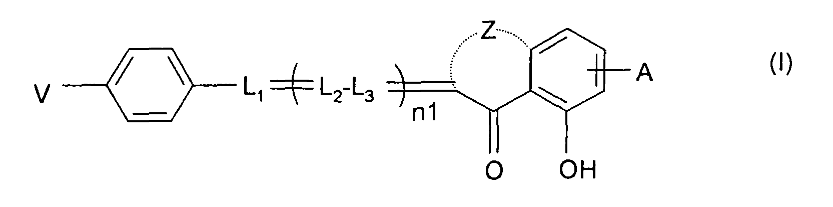 où Z représente une simple liaison ou un groupe atomique nécessaire pour compléter un cycle à 5 à 9 chaînons, le groupe atomique étant constitué par des atomes choisis parmi l'hydrogène, le carbone, l'oxygène, l'azote et le soufre ; L₁, L₂ et L₃ représentent chacun un atome d'azote ou un groupe méthine substitué ou non substitué ; n1 représente 0, 1 ou 2 ; V représente un groupe amino substitué ou non substitué ou un groupe alcoxy substitué ou non substitué, et V peut former un cycle condensé avec le cycle benzénique ; et A représente un substituant qui peut être un cycle condensé au cycle benzénique ; ou la formule (II) : 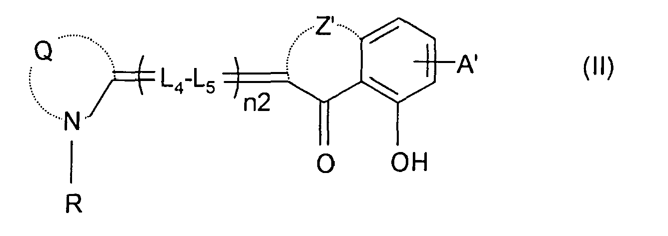 où Z' a la même signification que Z ; L₄ et L₅ ont la même signification que L₁, L₂ et L₃ ; n2 représente un entier de 1 à 4 ; Q représente un groupe atomique nécessaire pour compléter un hétérocycle à 5 ou 6 chaînons avec l'atome d'azote, l'hétérocycle peut avoir un substituant et peut en outre être un cycle condensé ; R représente un groupe alkyle ; et A' a la même signification que A.

2. Dispositif de conversion photoélectrique selon la revendication 1 où ledit hétérocycle complété par Q dans la formule (II) comprend un noyau benzothiazole, un noyau benzoxazole, un noyau 2-quinoléine, un noyau 4-quinoléine ou un noyau indolénine.

3. Dispositif de conversion photoélectrique selon la revendication 1 ou 2 où le noyau acide comprenant le cycle complété par Z dans la formule (I) ou Z' dans la formule (II) est l'une des structures (a) à (e) suivantes, qui peuvent avoir un ou plusieurs substituants.

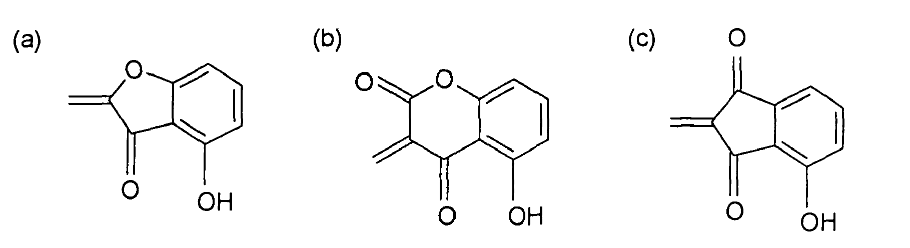

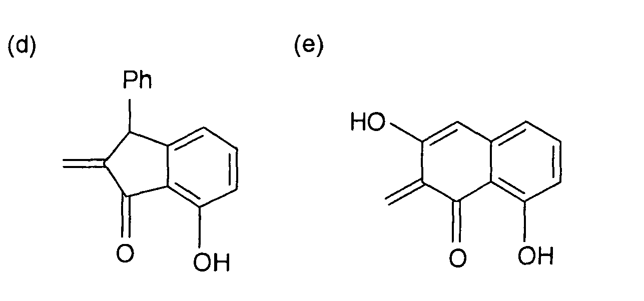

4. Dispositif de conversion photoélectrique selon l'une quelconque des revendications 1 à 3 où lesdites particules semi-conductrices sont des particules de dioxyde de titane.

5. Cellule photoélectrique ayant le dispositif de conversion photoélectrique selon l'une quelconque des revendications 1 à 4.
